# EUROPÄISCHE PATENTSCHRIFT

(11) **EP 0 888 527 B1**
(45) Veröffentlichungstag und Bekanntmachung des Hinweises auf die Patenterteilung: **06.11.2002**
(21) Anmeldenummer: 97918038.7
(22) Anmeldetag: 18.03.1997
(51) Int. Cl.: G01J 1/58, G01T 1/20

(54) **STRAHLUNGSERMITTLUNGSVORRICHTUNG**
RADIATION DETECTION DEVICE
DISPOSITIF DETECTEUR DE RAYONNEMENT

(30) Priorität: 18.03.1996 DE 19610538
(43) Veröffentlichungstag der Anmeldung: 07.01.1999
(60) Teilanmeldung: 01124092.6
(73) Patentinhaber: Deutsches Krebsforschungszentrum Stiftung des öffentlichen Rechts, 69120 Heidelberg (DE)
(72) Erfinder: GROSS, Karlheinz, D-69122 Dossenheim (DE); SINN, Hannsjörg, D-69118 Wiesloch (DE); MAIER-BORST, Wolfgang, D-69122 Dossenheim (DE); KAUS, Michael, D-69118 Heidelberg (DE); SCHRENK, Hans-Hermann, D-67278 Zeiskam (DE); STEHLE, Gerd, D-69123 Heidelberg (DE)
(74) Vertreter: Castell, Klaus, Dr.
(86) Internationale Anmeldenummer: DE9700564
(87) Internationale Veröffentlichungsnummer: WO97035171

(56) Entgegenhaltungen:
- EP-A- 0 429 810
- US-A- 4 314 743
- US-A- 5 095 212
- US-A- 5 323 011
- US-H- H1 364

## Beschreibung

Die Erfindung betrifft eine Vorrichtung zum Ermitteln von Eingangsstrahlung, in Form von γ- oder β-Strahlung, mit mindestens einem Erfassungselement, das einen Sensorteil (Szintillator, Wellenlängenschieber und dgl.) zur Umwandlung der Eingangsstrahlung in im UV-, sichtbaren oder IR-Teil des elektromagnetischen Spektrums liegende Photonen (z.B. Szintillationslicht) und einen optischen Verstärkerteil aufweist, der das vom Sensorteil gewandelte Licht aufnimmt, zur weiteren Verarbeitung weiterleitet und dabei verstärkt.

Vorrichtungen bzw. Detektoren zum Ermitteln von Eingangsstrahlung aus dem Wellenlängenspektrum der Röntgen- und γ-Strahlung sind in unterschiedlichen Ausführungsformen bekannt. Große Bedeutung haben diese Vorrichtungen auf dem Gebiet der Medizin, insbesondere im Zusammenhang mit bildgebenden Verfahren, wie beispielsweise PET (Positron Emission Tomography), SPECT (Single Photon Emission Computed Tomography), Szintigraphie (Anger-Kamera), Röntgentomographie CT (Computed Tomography), erlangt.

Unter den verschiedenen bildgebenden Verfahren in der Medizin besitzt die MR-(kernmagnetische Resonanz bzw. Nuclear Magnetic Resonance) Tomographie aufgrund hervorragender Bildqualität und dreidimensionaler Bildinformation große diagnostische Bedeutung. Diese beruht auf der Messung der dreidimensionalen Verteilung der Wasserstoffatome. Sie ist anderen Röntgen- bzw. nuklearmedizinischen Verfahren, wie beispielsweise Szintigraphie und PET bezüglich der Auflösung um Größenordnungen überlegen. Aus diesen Gründen eignet sich die MR-Tomographie insbesondere zur Lokalisationsdiagnostik. Demgegenüber bestehen die Stärken der Szintigraphie oder PET in der Erfassung physiologischer Parameter.

Es besteht deshalb ein Bedarf an einem medizinischen Instrument, das die Vorteile der Bildgebungsverfahren aufgrund physiologischer Parameter, z.B. Szintigraphie/PET, mit denjenigen der auf Strukturinformation beruhenden Bildgebungsverfahren, wie beispielsweise MR-Tomographie, sinnvoll vereinigt.

Versuche, Informationen aus beiden Systemen nachträglich zu kombinieren sind u.a. am Deutschen Krebsforschungszentrum durchgeführt worden (L. R. Schad, "Three Dimensional Image Correlation of CT, MR, and PET: Studies in Radiotherapy Treatment Planning of Brain Tumors", Journal of Computer assisted Tomography, 1987, II (6), S. 948-954).

Eine Problematik bei der nachträglichen Kombination von Information aus mehreren unterschiedlichen bildgebenden Systemen besteht jedoch darin, daß der menschliche Körper nicht starr ist. Es treten deshalb zwischen den unterschiedlichen bildgebenden Systemen Übertragungsprobleme auf. Diese versucht man mittels digitaler Bildverarbeitung zu kompensieren, was bei Tumoren im Kopfbereich durch stereotaktische Maßnahmen auch gelingt.

Wünschenswert wäre ein Kombinationsgerät, das die simultane Erfassung von Strukturinformation und die dreidimensionale Verteilung von Radioaktivität ermöglicht Dies ist durch eine Kombination aktuell verfügbarer Geräte nicht erreichbar. Haupthindernisse stellen dabei das hohe statische Magnetfeld, die zeitlich geschalteten, starken Magnetfeld-Gradienten, die gepulst eingestrahlten elektromagnetischen Wellen im MHz-Bereich und der geringe vorhandene Raum für weitere Detektionseinrichtungen im Zentralbereich eines MR-Tomographen dar. Aus diesem Grund können keine Detektoren auf elektronischer Basis im Innern eines MR-Tomographen benutzt werden. Das bedeutet, daß zur Zeit in PET-Geräten verwendete Kristalle (BGO, BaF₂ und dergleichen), an die ein Photomultiplier direkt gekoppelt ist, für das angestrebte Kombinationsgerät untauglich sind.

Diese Probleme können zumindest dadurch teilweise überwunden werden, daß anstelle von Kristallen Bündel aus szintillierenden Lichtwellenleitern verwendet werden. Erste Versuche mit gebündelten szintillierenden Lichtwellenleitem sind bereits publiziert worden (R. C. Chaney et al., 'Testing the Spatial Resultion and Efficiency of Scintillating Fiber PET Moduls", IEEE Transactions of Nuclear Science, Band 39, Nr. 5, Oktober 1992). In einem Seminarvortrag, gehalten am Deutschen Krebsforschungszentrum im Sommer 1995, hat Professor P.P. Antich über die ersten Versuche eines Kombinationsgerätes (PET/MR-Tomographie) berichtet. Bei diesen Instrumenten sind szintillierende Kunststoff-Lichtwellenleiter verwendet worden. Das am Ende des Faserbündels austretende Szintillationslicht wurde mit Photomultipliem in ein elektrisches Signal gewandelt (der Abstand Szintillationslicht - Photomultiplier betrug dabei ca. 5 m). Große Probleme bereitete bei diesen Experimenten die nicht vernachlässigbare optische Dämpfung der szintillierenden Kunststoffasern, sowie die geringe Anzahl der im szintillierenden Lichtwellenleiter erzeugten Photonen. Genau diese Probleme werden durch die Erfindung auf elegante Weise gelöst, wie nachfolgend im einzelnen ausgeführt.

Alternativ zu Photomultipliern werden MCA's (Multi-Channel-Plates, Vielkanal-Platten-Verstärker) zur Ermittlung schwacher Lichtsignale verwendet. Nachteilig bei beiden Systemen ist, daß zu ihrem Betrieb Hochspannung im Bereich von mehreren hundert Volt benötigt wird. Dies verteuert mit derartigen Detektoren ausgerüstete Geräte.

Zur Detektion von Röntgen oder γ-Quanten werden auch elektronische Bauteile verwendet. Hierbei handelt es sich meist um PIN- und Avalanche-Dioden, die ein ausgeprägtes thermisches Rauschverhalten zeigen und schon aus diesem Grund grundsätzlich optischen Verstärkern unterlegen sind.

Optische Verstärker sind aus physikalischen Gründen elektronischen Verstärkern grundsätzlich überlegen, weil sie ein besseres Signal/Rauschverhältnis haben.

Zu dem vorstehend angeführten Stand der Technik ist zusammenfassend festzustellen, daß die Verstärkerteile bekannter Strahlungsermittlungsvorrichtungen nur bedingt geeignet sind, sehr schwache Signale zu verstärken, und diese Information über große Entfernungen zu übertragen. Ein weiterer Nachteil der bekannten Vorrichtungen besteht darin, daß sehr schwaches Szintillations- bzw. Fluoreszenzlicht insbesondere in schwer zugänglichen Versuchs- bzw. Untersuchungsanordnungen nur schwer nachweisbar ist. Femer ist eine räumliche Trennung zwischen dem Erfassungsort und dem Auswertungsort aufgrund der schwachen Signale nur schwer zu erreichen.

Zum allgemeinen Stand der Technik wird auf die folgenden Druckschriften verwiesen:
- US-H 1364; zeigt eine Anordnung in der ein Lichtwellenleiter mit optisch gepumpten Kern als Verstärkerteil Funktioniert.
- DE-OS 23 51 450; diese Druckschrift betrifft einen Szintigraphie-Kollimator, der zur Fokussierung der aus einem γ-Strahl-emittierenden Untersuchungsobjekt austretenden γ-Strahtung dient.
- DE-OS 24 46 226; diese Druckschrift betrifft ein Szintillator, der aus Metallionen dotiertem Alkali-Halogenid-Material besteht.
- DE 39 18 843; diese Druckschrift betrifft einen Röntgendetektor, der aus einer Reihe kleiner Stäbe aus Szintillator-Material besteht.
- DE 33 27 031 A1; diese Druckschrift betrifft ein Röntgengerät, bei dem ein spaltförmiges Röntgenstrahlenbild in ein sichtbares Bild umgesetzt und über eine Lichtleiteranordnung einem Bildverstärker zugeführt wird, dessen Ausgangsbild mittels eines Wandlers in ein elektrisches Signal umgesetzt wird.
- DE 43 34 594; diese Druckschrift betrifft einen Detektor für energiereiche Strahlung für die Computertomographie, wobei eine Reihe von Szintillatoren vorgesehen ist, denen entsprechende, durch Schlitze voneinander getrennte Lichtleiter zugeordnet sind.
- EP 0 471 926 A2; diese Druckschrift betrifft ein schnelles strahlungsstabiles CT-Szintillätorsystem, bei dem ein spezielles Granatmaterial verwendet wird.

Der vorliegenden Erfindung liegt die Aufgabe zugrunde, eine Strahlungsermittlungsvorrichtung der im Oberbegriff des Anspruchs 1 genannten Art zu schaffen, die für bildgebende Verfahren mit hoher Ortsauflösung auch für schwache Eingangsstrahlung sowie insbesondere im Zusammenhang mit schwer zugänglichen Anordnungen eingesetzt werden kann.

Gelöst wird diese Aufgabe durch die kennzeichnenden Merkmale der Ansprüche 1, 3, 4 und 7. Vorteilhafte Weiterbildungen der Erfindung sind in den abhängigen Ansprüchen angegeben.

Die Erfindung schafft demnach mit anderen Worten eine Strahlungsermittlungseinrichtung mit einem Erfassungselement, dessen Verstärkerteil nach Art eines Lasers eine optische Verstärkung von Szintillationslicht durch einen optischen Wellenleiter gewährleistet, dessen Material optisch gepumpt ist. Durch das optische Pumpen werden die durch den Sensorteil aus der Eingangsstrahlung gewonnenen Photonen mehrtausendfach verstärkt. Ein entscheidender Vorteil der erfindungsgemäßen Vorrichtung besteht darin, daß der Lichtwellenleiter, und damit der Verstärkerteil grundsätzlich in unmittelbarer Nähe des Photonenerzeugungsorts angeordnet werden kann, oder aber in der Nähe eines optischen Leiters, der diese Photonen zum Verstärkerteil überträgt. Während im ersten Fall, der Anordnung des Lichtwellenleiters in unmittelbarer Nähe des Photonenerzeugungsorts, auch schwächste Eingangsstrahlung bzw. Eingangsstrahlung in schwer zugänglichen Anordnungen erfaßt werden kann, besteht der wesentliche Vorteil des zweiten Falls, der entfernten Anordnung des gepumpten optischen Lichtwellenleiters vom Photonenerzeugungsort, darin, daß die Photonenverstärkung ungestört von Störfeldern, wie beispielsweise großen Magnetfeldern erfolgen kann.

Besondere Bedeutung für die Erfindung hat die Tatsache, daß die am Wechselwirkungsort erzeugten Photonen sofort oder gegebenenfalls über Zwischenschritte eine optische Verstärkung erfahren. Dies macht die Ermittlung sehr weniger Photonen möglich. Das Erfassungselement stellt somit ein sehr kompaktes, richtungsselektives. hocheffizientes Bauteil dar, das es zudem gestattet, Information über größere Entfernungen zu übertragen und die zur Verstärkung benötigte Energie (Pumplicht in rein optischer Form) ebenfalls aus größerer Entfernung zu beziehen. Dabei findet eine räumliche und funktionelle Trennung der für die Wandlung zuständigen Abschnitte (z.B. γ-Quant → ν-Photon → Verstärkung → Weiterleitung → elektrisches Signal) statt.

Der Sensorteil und der optische Verstärkerteil arbeiten jeweils ohne elektronische Bauteile. Das heißt, (elektrische) Energie wird nicht über Drähte, sondern rein optisch zugeführt, was für praktische Anwendungen ein entscheidender Vorteil gegenüber existierenden γ- und Röntgendetektoren auf Siliciumbasis ist. Zwischen den peripher angeordneten elektronischen Baugruppen, z.B. dem Ausleseteil (z.B. CCD-Kamera mit Compter-Interface), der Pump-Lichtquelle (z.B. eine Laserdiode, die zur Erzeugung der Besetzungsinversion im optischen Verstärkerteil benötigt wird) auf der einen Seite und dem rein optischen Teil auf der anderen Seite mit dem Sensorteil, der für die Konvertierung der Röntgen- bzw. γ-Quanten verantwortlich ist, und dem optischen Verstärkerteil können daher Entfernungen von mehreren Metern bis hunderten von Metern liegen.

Die für die Erfindung benötigten speziellen optischen Lichtwellenleiter stehen bereits zur Verfügung bzw. können den Kundenbedürfnissen entsprechend hergestellt werden (Le Verre fluore). Bevorzugt handelt es sich dabei um Schwermetall-Fluorid-Gläser (HMFG, Heavy Metal Fluorid Glass, Halide Glasses), wobei diese mit Atomen aus der Gruppe der Lanthaniden (Selten-Erdmetalle bzw. RE: rare earth) des Periodensystems der Elemente dotiert sind. Zur Gruppe der Lanthaniden zählen: Cer (Ce), Praseodym (Pr), Neodym (Ne), Promethium (Pm), Samarium (Sm), Europium (Eu), Gadolinium (Ga), Terbium (Tb), Dysprosium (Dy), Holmium (Ho), Erbium (Er), Thulium (Tm), Ytterbium (Yb) und Lutetium (Lu). Der Nachweis von Lasertätigkeit wurde für folgende Selten-Erdmetalle in Schwermetall-Fluorid-Gläsem nachgewiesen (Stand 1991, Quelle: Fluoride Glass Fiber Optics, Ishar D. Aggarwal, Gand Lu, Academic Press, Inc., 1991): Nd, Er, Ho, Tm. Zwischenzeitlich wurde für nahezu sämtliche Selten-Erdmetalle Laseraktivität nachgewiesen. Weitere bevorzugte Lichtwellenleiter umfassen glaskeramisches Material, Chalkogenidgläser oder Phosphatgläser.

Bei den obengenannten Gläsern, insbesondere den Schwermetall-Fluorid-Gläsern handelt es sich um Mehrkomponenten-Gläser.

Ein Vorteil gegenüber dotierten Silikatgläsem besteht u.a. darin, daß wesentlich höhere Dotierungskonzentrationen mit Selten-Erdmetallen erfolgen können, woraus ein größerer Wirkungsgrad für optische Verstärker bzw. Faserlaser resultiert.

Ein weiterer Vorteil von mit Seiten-Erdmetallen dotierten Schwermetall-Fluorid-Gläsern besteht darin, daß dieses Material im Gegensatz zu den herkömmlichen Silikatglas-Lichtwellenleitern kristallartige Eigenschaften aufweist. Schwermetall-Fluorid-Gläser bestehen aus Materialien, wie beispielsweise BaF, CeF, die bereits in kristalliner Form als Strahlungsdetektoren verwendet werden. Von Vorteil ist, daß Schwermetall-Fluorid-Gläser eine hohe Dichte aufweisen, die ausreicht, für γ-Strahlen die erforderliche "Stopping Power (dE/dx; Energieverlust E pro Wegstrecke x)" zu erreichen. Diese "Stopping Power" ist mit den bislang auf diesem Gebiet sowie in der Hochenergie-Physik üblichen Kunststoff-Fasern nicht erzielbar. Ein weiterer Vorteil durch die Verwendung von Schwermetall-Fluorid-Glas als optischer Wellenleiter besteht darin, daß diese Lichtwellenleiter selbst als Kollimator fungieren können. Ein Vorteil der Schwermetall-Fluorid-Gläser gegenüber Kristallen zur Strahlungserfassung besteht in ihrer einfachen Handhabung, ihrer problemlosen Verarbeitbarkeit und ihrer billigen Herstellbarkeit.

Gemäß einer vorteilhaften Weiterbildung der Erfindung wird keine direkte Besetzungsinversion durch Licht der Pumpwellenlänge γₗ benutzt; vielmehr wird ein physikalischer Auf-Konvertierungsprozeß (up-conversion) bzw. eine Variante davon, der sogenannte lawinenartige Aufkonvertierungs-Prozeß (Avalanche conversion) benutzt. Die lange Fluoreszenz-Lebensdauer von Selten-Erdionen in Schwermetall-Fluorid-Gläsern begünstigt die optische Frequenz-Aufkonvertierung (optical frequency up-conversion). Bei diesem Prozeß wird zuerst ein Selten-Erdion auf einen langlebigen, intermediären Anregungszustand gehoben, von wo aus es in einem zweiten Schritt auf einen noch höher gelegenen Zustand gelangt.

Der erfindungsgemäß zur Verstärkung des Szintillationslichts eingesetzte, gepumpte optische Lichtwellenleiter kann in unterschiedlicher Gestalt gebildet sein. Vorteilhafterweise ist der optische Lichtwellenleiter als optische Faser gebildet, die bevorzugt in an sich bekannter Art durch einen Mantel umschlossen ist. Die Einspeisung des Pumplichts in die Faser erfolgt entweder direkt in den Kern der Faser oder in den inneren Bereich des Fasermantels. Der Fasermantel besteht bevorzugt aus szintillationsfähigem Material und bildet dadurch den Sensorteil der Erfassungsvorrichtung.

Gemäß einer vorteilhaften Weiterbildung der Erfindung kann neben kontunierlichem Pumplicht auch gepulstes Pumplicht verwandt werden, so daß der optische Verstärker zeitlich getriggert bzw. aktiviert werden kann. Dadurch können koordinierte Abläufe besser beobachtet werden. Als Beispiel hierzu möge eine Anwendung bei der Herzszintigraphie (Myokardszintigraphie) gelten. So kann der optische Verstärker über die simultane Ableitung des Elektrokardiogramms bei bestimmten Phasen der Herzaktion eingeschaltet werden, wobei die Einschaltphasen den Bereich von Picosekunden erreichen können. Diese Technik läßt sich zur Kompensation von Bewegungsartefakten, die z.B. von Atmung oder Kreislauf verursacht werden, einsetzen.

Neben Einzelaufnahmen können auch durch periodisch gepulstes Einschalten Zeitserien detektiert werden. Dies ist vorteilhaft zur kinetischen Untersuchung der Herzfunktion und z.B. zur Darstellung von Narbengewebe nach einem Herzinfarkt.

Der erfindungsgemäß vorgesehene Lichtwellenleiter kann auch in säulenartiger Mikrostruktur gebildet sein, die beispielsweise auf einem Siliziumwafer aufgewachsen ist. Neben der Säulenform kommen für die Mikrostruktur-Elemente auch andere Formen in Betracht, die für den jeweiligen Anwendungszweck geeignet sind. Planare Wellenleiter sind für spezielle Einsatzwecke ebenfalls geeignet.

Wie vorstehend erläutert, kommen als photonenauslösende Stoffe im Lichtwellenleiter beispielsweise Selten-Erd-Metalle in Betracht. Alternativ hierzu können als Dotierstoff Farbstoffmoleküle verwendet werden.

Ein bevorzugter Anwendungsbereich der erfindungsgemäßen Vorrichtung liegt im Bereich von Radioimmuno-Essays, bei denen β-Strahlung ausgewertet wird. β-Strahlung besitzt nur eine sehr geringe Reichweite. Aktive Verstärkerelemente auf der Grundlage des erfindungsgemäßen gepumpten optischen Lichtwellenleiters, beispielsweise in Form von Faserbündeln, oder in Form säulenartiger Mikrostrukturen auf einem Siliziumwafer (bzw. einem Gallium-Arsenit-Substrat, auf dem Laserdioden und Photodioden zur Detektion gemeinsam realisiert sind) können bei dieser Anwendung als Mikro-Szintillator und Mikro-Verstärker von durch β-Strahlung erzeugtem Szintillationslicht dienen. Ein besonderer Vorteil dieser Anwendung besteht darin, daß diese Elemente als Ersatz für normales Füllmaterial dienen können. Erzielbar ist durch eine derartige Anordnung ein sehr hohes Auflösungsvermögen bei der Erfassung von β-Strahlung. Von Vorteil ist außerdem die Wiederverwendbarkeit der Anordnung, sowie deren bequeme Einsetzbarkeit, da die Auswertung ähnlich wie bei Filmmaterial erfolgen kann.

Eine weitere bevorzugte Anwendung der erfindungsgemäßen Vorrichtung besteht auf dem Gebiet der Biosensorik. Als Beispiel soll vorliegend eine Anwendung aus dem Bereich der Molekularbiologie kurz erläutert werden, bei der Fluoreszenzlicht verstärkt werden soll. Dabei werden Antikörper an eine lichtverstärkende Faser oder einen planaren Wellenleiter aus lichtverstärkenden Material gemäß der vorliegenden Erfindung gekoppelt. Hierzu wird bevorzugt ein Teil des äußeren Mantels bzw. der äußeren Schicht des Wellenleiters durch Anätzen porös gemacht. Das Antigen ist mit einem Fluoreszenz-Molekül beladen. Ein Teil des von innen oder außen angeregten Fluoreszenzlichts eines einzigen Farbstoffmoleküls dringt in das aktive Strukturelement (die lichtverstärkende Faser bzw. den aktiven planaren Wellenleiter) ein und wird dort lokal verstärkt. Das lokal verstärkte Fluoreszenzlicht kann dann verlustfrei zu einem räumlich entfernten Auswertesystem übertragen werden. Der Vorteil dieser Anordnung besteht demnach insbesondere darin, daß der Ort der Verstärkung räumlich getrennt vom Ort der Auswertung gewählt werden kann.

Zusammenfassend bietet die vorliegende Erfindung u.a. folgende Vorteile:
- Selbst schwächste Signale können durch die erfindungsgemäße Verstärkung erfaßt und zur Auswertung gegebenenfalls über große Strecken transportiert werden.
- Es gelingt der Nachweis von selbst sehr schwachem Szintillations- bzw. Fluoreszenzlicht in mit herkömmlichen Detektoren nicht bzw. nur schwer zugänglichen Anordnungen.
- Eingangsstrahlung kann lokal erfaßt, verstärkt und an ein entfernt angeordnetes Auswertungssystem, beispielsweise eine CCD-Kamera übertragen werden.
- Es gelingt die räumliche Trennung des Umsetzungsorts von γ- oder Röntgen-Quanten in Lichtquanten bei gleichzeitiger Verstärkung durch das optische Pumpen sowie durch das spätere Umwandeln des optischen Signals in elektrisches Signal.
- Die erfindungsgemäße Strahlungsermittlungseinrichtung kann kostengünstig hergestellt werden.

Nachfolgend wird die Erfindung anhand der Zeichnung beispielhart näher erläutert; es zeigen:
- Fig. 1: schematisch eine erste Ausführungsform der Erfassungseinrichtung der erfindungsgemäßen Strahlungsermittlungsvorrichtung;
- Fig. 2: eine zweite Ausführungsform der Erfassungseinrichtung der erfindungsgemäßen Strahlungsermittlungsvorrichtung;
- Fig. 3: eine dritte Ausführungsform der Erfassungseinrichtung der erfindungsgemäßen Strahlungsermittlungsvorrichtung;
- Fig. 4: eine vierte Ausführungsform der Erfassungseinrichtung der erfindungsgemäßen Strahlungsermittlungsvorrichtung;
- Fig. 5: eine spezielle Anwendung der Erfassungseinrichtung der erfindungs-gemäßen Strahlungsermittlungsvorrichtung zum Ermitteln von β-Strahlung; und
- Fig. 6: eine spezielle Anwendung der Erfassungseinrichtung der erfindungsgemäßen Strahlungsermittlungsvorrichtung als Fluoreszenzsensor.

Sämtliche in der Zeichnung dargestellte Erfassungseinrichtungen weisen einen integralen Aufbau aus Sensorteil und Verstärkerteil auf.

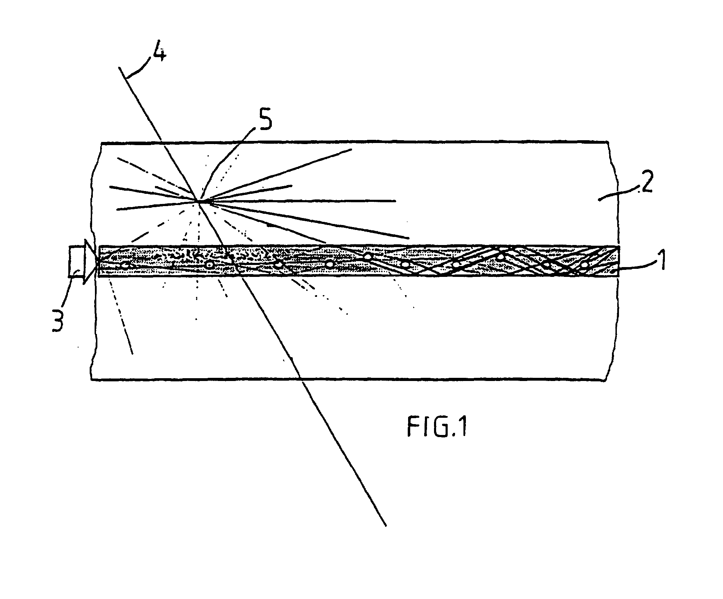

In Fig. 1 ist eine erste Ausführungsform des Erfassungselements der erfindungsgemäßen Vorrichtung zur Ermittlung von Eingangsstrahlung gezeigt. Bei dem Erfassungselement handelt es sich um einen optischen Faserverstärker, bestehend aus einem Faserkem 1 und einem den Faserkern umschließenden Mantel (Cladding) 2. Der Kern 1 bildet den Verstärkerteil und besteht aus einem optisch aktiven Material, das optisch gepumpt ist, wie durch einen Pfeil 3 gezeigt, der die Einspeisungsrichtung von Pumplicht angibt. Der Mantel 2 besteht aus einem szintillierenden Material, das einen geringeren optischen Brechungsindex wie der Faserkern 1 aufweist.

Als Material für den Kern 1 kommt bevorzugt ein Schwermetall-Fluorid-Glas in Betracht, das im Gegensatz zu herkömmlichen, für Fasern verwendeten Silikatglas kristallartige Eigenschaften hat. Der Mantel 2 besteht bevorzugt ebenfalls aus einem Schwermetall-Fluorid-Glas, das jedoch mit einem szintillationsfähigen Dotierstoff dotiert ist. Bei dem Dotierstoff handelt es sich bevorzugt um Selten-Erd-Metalle, insbesondere um Cer, Nd, Pr, Er, Tm. Da Schwermetall-Fluorid-Glas eine hohe Dichte aufweist, läßt sich für γ-Strahlen eine ausreichend große "Stopping Power" erreichen; d.h. ein aus diesem Material aufgebauter Lichtwellenleiter ist nicht nur zum Nachweis niedrigenergetischer Strahlung, sondern auch zum Nachweis hochenergetischer Strahlung, wie beispielsweise γ-Strahlung geeignet, weshalb es für den erfindungsgemäßen Einsatz bevorzugt ist.

Innerhalb des Faserkems 1 sind mittels kleiner Kreise optisch aktive Zentren des gepumpten Kernmaterials schematisch gezeigt.

Zur Verdeutlichung der Funktionsweise der erfindungsgemäßen Vorrichtung ist in Fig. 1 die Bahn 4 eines ionisierenden Teilchens bzw. eines Gamma-Quants dargestellt, das den optischen Faserverstärker durchsetzt und bei Wechselwirkung mit dem Dotierstoff im Mantel 2 Szintillationslicht erzeugt, wie in Fig. 1 an der Stelle 5 des Mantels 2 gezeigt, von der ausgehend das Szintillationslicht allseitig bzw. isotrop abgestrahlt wird. Ein Teil des Szintillationslichts bzw. der Photonen vom Wechselwirkungsort 5 tritt in den Faserkem 1 ein und wird durch den dort ablaufenden optischen Verstärkungsprozeß (geeignete Frequenz vorausgesetzt) vervielfacht. Insbesondere wird durch das in den Kern 1 eingestrahlte Pumplicht dort eine Besetzungsinversion erzeugt, die ebenfalls in den Kern 1 eintretenden Photonen der Szintillationsstrahlung lösen induzierte Emissionen an den optisch aktiven Zentren aus und werden dadurch innerhalb des Kerns verstärkt. Sie werden an geeigneter Stelle zur weiteren Verarbeitung aus der Faser 1 ausgekoppelt.

Grundsätzlich kommen als Material für den Mantel 2 auch geeignete szintillierende Kunststoffe in Betracht, die in der wissenschaftlichen Literatur ausführlich beschrieben sind. Derartiges Kunststoffmaterial findet insbesondere in der Hochenergie-Physik bis hin zu medizinischen Anwendung breite Verwendung. Ein Nachteil bei der Verwendung von szintillierenden Kunststoff besteht darin, daß bei Wechselwirkung mit γ- bzw. Röntgen-Strahlung der Compton-Effekt dominiert; d.h. die Energie des Gamma-Quants bzw. des Röntgen-Quants wird nur teilweise absorbiert und es findet eine Richtungsänderung des einfallenden Gammaquants statt. Ein weiterer Nachteil dieses Kunststoffmaterials besteht in seiner geringen mittleren Abschwächung (stopping power) für die Eingangsstrahlung, die durch die geringe Dichte dieses Materials bedingt ist, wodurch der Wirkungsgrad für die Photonenerzeugung ungünstig ist. Schließlich besitzt dieses Material eine hohe innere Dämpfung, wodurch das erzeugte Szintillationslicht nur über kurze Strekken übertragen werden kann. Diese Nachteile von szintillierendem Kunststoff werden bei der erfindungsgemäßen Verwendung eines optischen Faserverstärkers durch die optische Verstärkung teilweise ausgeglichen, weshalb es grundsätzlich zur Verwendung mit der erfindungsgemäßen Strahlungsermittlungsvorrichtung in Betracht kommt.

Als optischer Verstärker kann alternativ ein mit Farbstoffmolekülen dotierter Kunststoffaserkern dienen, dre von einem szintillierenden Mantel umgeben ist.

Die Länge der Faser 1, 2 hängt vom Einsatzzweck ab und beträgt bevorzugt zwischen 5 mm und 5 m.

Ein Vorteil des als optische Faser aufgebauten, optisch gepumpten Lichtwellenleiters 1, 2 besteht in der hohen erreichbaren Lichtverstärkung, in der äußerst kompakten Bauform, die auch einen Einsatz mit Anordnungen zuläßt, die durch herkömmliche Detektoren nicht zugänglich sind, und in der kostengünstigen Herstellbarkeit.

Die Erfindung ist jedoch nicht auf eine optische Faser beschränkt. Vielmehr kommen auch Kristalle oder planare Lichtleiter in Betracht, die aus einem zur optischen Verstärkung geeigneten Material hergestellt sind. Schließlich kann eine Mehrzahl derartiger Erfassungselemente, bzw. Fasem kombiniert werden.

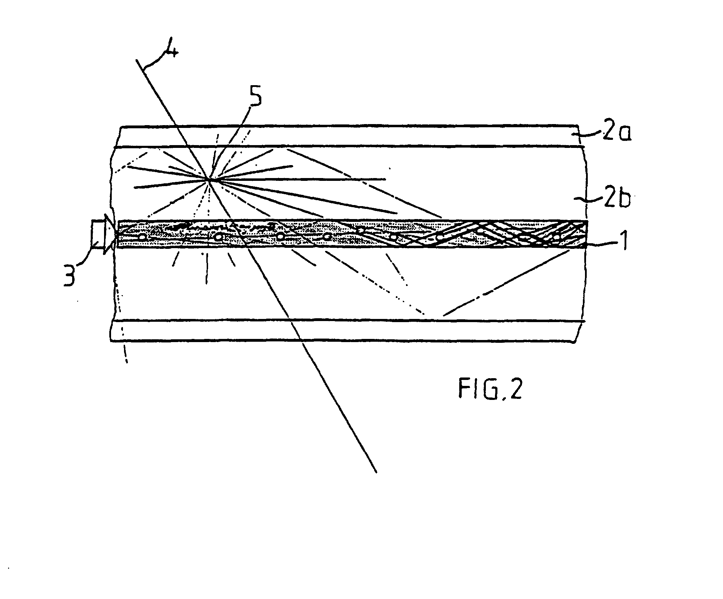

Eine zweite Ausführungsform des Erfassungselements der erfindungsgemäßen Vorrichtung ist in Fig. 2 gezeigt. Diese Ausführungsform unterscheidet sich von der in Fig. 1 gezeigten ersten Ausführungsform durch die Verwendung eines Doppelmantels (Double Cladding) 2a, 2b. Der Aufbau des inneren Mantels 2a entspricht dem Aufbau des Mantels 2 der Ausführungsform von Fig. 1, besteht also aus einem szintillierenden Fasermaterial, während der äußere Fasermantel 2a aus einem herkömmlichen, nicht szintillierenden Fasermaterial bestehen kann, das einen zum Material des inneren Fasermantels 2b unterschiedlichen Brechungsindex derart hat, daß im inneren Fasermantel 2b durch Szintillation erzeugtes Licht an der Grenzschicht zwischen dem Fasermantel 2a und dem Fasermantel 2b reflektiert wird. Der Vorteil dieser Maßnahme besteht darin, daß dieses reflektierte Licht, das für den Verstärkungsvorgang bei der Ausführungsform gemäß Fig. 1 nicht zur Verfügung steht, dem Verstärkungsvorgang ebenfalls zugeführt wird.

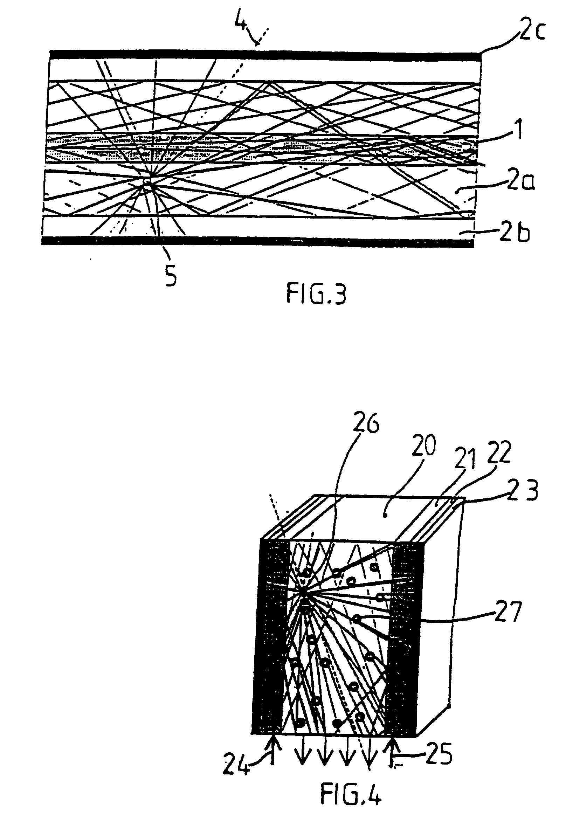

Fig. 3 zeigt eine dritte Ausführungsform des faserförmigen Erfassungsmaterials, das sich von der Ausführungsform gemäß Fig. 2 dadurch unterscheidet, daß das Pumplicht nicht in den Faserkern 1, sondern in den inneren Fasermantel 2a eingekoppelt wird. Der Vorteil dieser Ausführungsform besteht in einem im Vergleich zu dem vorausgehenden Ausführungsformen eine günstigere Strahlungsführung des Pumplichts. Außerdem weist die optische Faser als äußerste Schicht eine lichtundurchlässige Faserumhüllung 2c auf, wodurch ein optisches Übersprechen auf die Nachbarfasern verhindert wird (optische Isolation).

Fig. 4 zeigt eine vierte Ausführungsform des Erfassungselements der erfindungsgemäßen Strahlungsermittlungsvorrichtung. Der optisch aktive Verstärkerteil wird bei dieser Ausführungsform durch einen anorganischen szintillierenden Kristall (z.B. BGO), der mit laseraktiven seltenen Erdmetallen dotiert ist. Somit stellt der Kristall gleichzeitig ein aktives Lasermedium und ein Szintillationsmedium dar. Als Beispiel kommt ein mit seltenen Erdmetallionen dotierter Kristall (z.B. Nd-BGO) zum Einsatz. Der BGO-Kristall 20, der in der dargestellten Ausführungsform Quaderform hat, besitzt einen ähnlichen Aufbau wie Fig. 3. Die äußerste lichtundurchlässige Schicht 23 dient der optischen Isolierung vom Nachbarelement. Die Schichten 21 und 22 entsprechen dem inneren (2a) und äußeren (2b) Mantelmaterial der Fig. 3. Sie dienen als optisches Transportelement zur Einkopplung des Pumplichtes in den BGO Kristall. Das Mantelmaterial kann aus lichtdurchlässigen Kunststoffen bestehen. In die Schichten 21 und 22 wird, wie durch die Pfeile 24 und 25 gezeigt, Pumplicht eingekoppelt, um den BGO-Kristall zu pumpen, und dadurch Szintillationslicht zu verstärken, das durch ein einfallendes Licht-Quant, beispielsweise ein Gamma-Quant im BGO-Kristall an der Position 26 im Kristallmaterial erzeugt wird. Mit Kreisen 27 sind wiederum die optischen aktiven Zentren bezeichnet. Ein Vorteil dieser Ausführungsform des Erfassungselements besteht darin, daß auf kostspielige Photomultiplier verzichtet werden kann. Durch die Vorverstärkung im optischen Verstärkerteil können nunmehr kostengünstige PIN- oder Avalanche-Dioden verwandt werden.

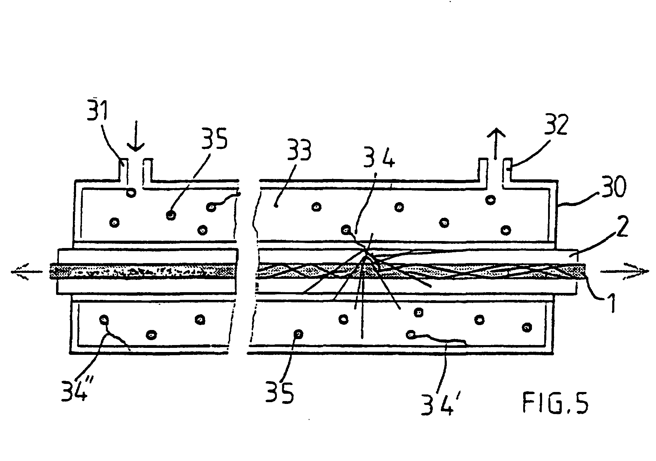

Fig. 5 zeigt eine bevorzugte Anwendung der erfindungsgemäßen Strahlungsermittlungseinrichtung gemäß den in den Fig. 1 bis 3 gezeigten Ausführungsformen in Gestalt eines optischen Faserverstärkers zum Nachweis von β-Teilchen. Demnach durchsetzt die Faser 1, 2 mittig einen länglichen Behälter 30 mit einem Einlaß 31 und einem Auslaß 32 für eine Trägerflüssigkeit 33, welche die Faser 1, 2 umspült und β-Teilchen 34 emittierende radioaktiv markierte Moleküle 35 oder z.B. markierte Zellen 35, markierte Bakterien 35 oder markierte Viren 35 enthält. Die β-Teilchen können nun in den Fasermantel 2 aus szintillierendem Material eindringen und Szintillationslicht erzeugen, das wie vorstehend erwähnt, durch den erfindungsgemäßen optischen Faserverstärker verstärkt wird. Erster Vorteil der Vorrichtung in Fig. 5 ist, daß die freigesetzten β-Teilchen sich in unmittelbarer Nähe zum Faserverstärker befinden. Dies ist wichtig, da β-Teilchen nur eine geringe Reichweite (wenige Millimeter) aufweisen. Zweiter Vorteil der Vorrichtung ist, daß das röhrenförmige Gebilde in beliebiger Länge vorliegen kann und damit die Detektionsoberfläche im Verhältnis zum Flüssigkeitsvolumen groß wird und die Empfindlichkeit zunimmt. Dritter Vorteil der Vorrichtung ist, da eine Wechselwirkung im Faserkem dem Volumenelement räumlich zugeordnet werden kann. Dies geschieht durch die Messung und den Vergleich des aus dem Faserkem 1 rechts und links austretenden verstärkten Lichts. Hierdurch ergibt sich die Möglichkeit zum Aussortieren z.B. von Molekülen, Zellen, Bakterien oder Viren. Vierter Vorteil ist, daß die Vorrichtung als Durchflußdetektor kontinuierlich betrieben werden kann. Dies ermöglicht die Kontrolle von kleinsten Mengen von radioaktiven Betastrahlen z.B. im Abwasser.

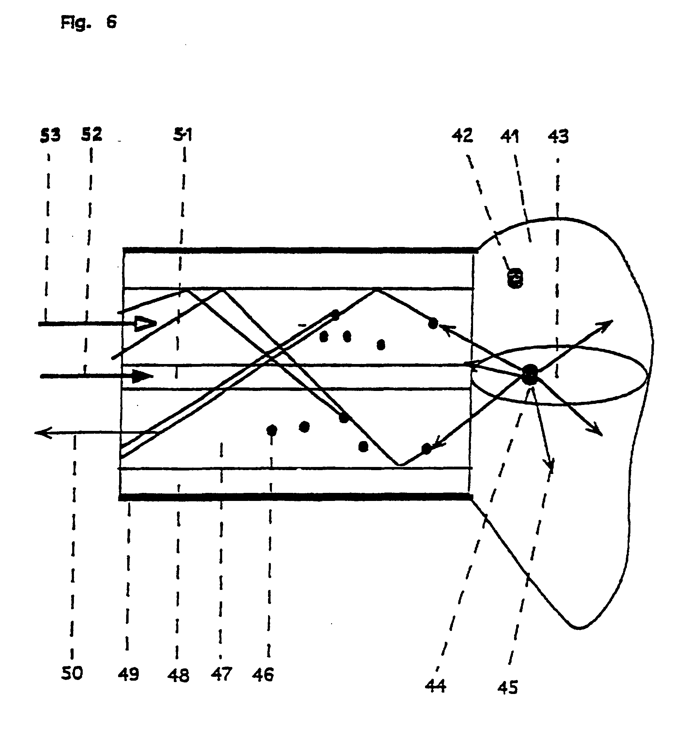

Nachdem in den Fig. 1 bis 5 Ermittlungseinrichtungen für Strahlungen gezeigt wurden, ist in Fig. 6 ein Beispiel für einen Biosensor zur "Single Molecule Detection" gezeigt, der die Detektion geringer Mengen an fluoreszenzmarkierten Substanzen in Flüssigkeiten oder im lebenden Organismus ermöglicht. Beispiele für fluoreszenzmarkierte Substanzen können Medikamente oder Makromoleküle, wie z.B. Proteine, sein. Ferner können fluoreszenzmarkierte Zellen, Bakterien oder Viren detektiert und quantifiziert werden. Die Ermittlung von Fluorezsenzlicht kan in Flüssigkeiten in-vitro oder in-vivo im lebenden Organismus stattfinden.

In Fig. 6 ist eine optische Faser gezeigt, die sich durch einen Kern 51- auszeichnet, durch den das Licht 52 zur Fluoreszenzanregung eingekoppelt wird, der aber nicht wie zuvor beschrieben als optischer Verstärkerteil dient. Der optische Verstärkerteil befindet sich hier im inneren Mantelteil 47. Äußerer Mantelteil 48 und innerer Mantelteil 47 bilden den bereits beschriebenen Lichtwellenleiter. Die Außenschicht 49 dient zum mechanischen Schutz der Faser, ist lichtundurchlässig und verhindert das Eindringen von Störlicht. Im Gegensatz zu den vorherigen Beispielen 1-5, bei denen die Photonen innerhalb des Sensorteils entstanden, entstehen die Photonen hier in unmittelbarer Nachbarschaft des Sensorteils. Der Sensorteil dient zur Aufnahme, Verstärkung und Weiterleitung des Fluoreszenzlichtes. Das eine Ende der Faser befindet sich z.B. in einer Flüssigkeit (Wasser, Blut, organisches Lösungsmittel etc. 41) oder in einem Gel 41 oder Sol (z.B. Zytosol von Zellen 41), in denen sich die zu detektierenden fluoreszenzmarkierten Substanzen 42 befinden. Im Medium 41, in das die Faser eintaucht, bildet sich durch das Fluoreszenzanregungslicht 52 ein örtlich definierter Lichtkegel 43. Gelangen durch Diffusion oder Konvektion fluoreszenzmarkierte Substanzen 42 in diesen Lichtkegel 43, wird die fluoreszenzmarkierte Substanz 42 in einen angeregten Zustand versetzt 44 und emittiert Fluoreszenzlicht 45. Ein Teil des Fluoreszenzlichts 45 tritt ins Innere des Fluoreszenzsensors ein. Das Material des inneren Mantels fungiert wiederum als optischer Faserverstärker und wird durch Pumplicht 53 aktiviert. Trifft nun ein Photon 45 auf ein optisch aktives Zentrum 46, kommt es in der Summe zur lawinenartigen optoelektronischen Verstärkung und am anderen Faserende tritt das verstärkte Fluoreszenzlicht 50 aus. Die optoelektronische Wandlung kann bevorzugt mit einer PIN- oder Avalanche-Diode durchgeführt werden.

## Patentansprüche

1. Verfahren zum Ermitteln von γ-Strahlung, bei dem in einem Sensorteil, welches in einem optischen Lichtwellenleiter (1, 2, 2a, 2b, 20) angeordnet ist, γ-Strahlung in im UV-, sichtbaren oder IR-Teil des elektromagnetischen Spektrums liegende Photonen umgewandelt und in einem optisch gepumpten (3, 24, 25) Verstärkerteil, welches ebenfalls in dem optischen Lichtwellenleiter (1, 2, 2a, 2b, 20) angeordnet ist, das vom Sensorteil umgewandelte Licht aufgenommen und verstärkend weitergeleitet wird.

2. Verfahren nach Anspruch 1, ***dadurch gekennzeichnet, daß*** der Verstärkerteil durch gepulstes Licht optisch gepumpt wird.

3. Vorrichtung zum Ermitteln von γ-Strahlung mit mindestens einem Erfassungselement, das ein Sensorteil und ein optisches Verstärkerteil aufweist, das vom Sensorteil gewandeltes Licht aufnimmt, zur weiteren Verarbeitung weiterleitet und dabei verstärkt, und der wenigstens einen optischen Lichtwellenleiter (1, 2, 2a, 2b, 20) aufweist, dessen Material zur Lichtverstärkung zumindest teilweise optisch gepumpt (3, 24, 25) ist, ***dadurch gekennzeichnet, daß*** der optische Lichtwellenleiter (1, 2, 2a, 2b, 20) ein Sensorteil zur Umwandlung von γ-Strahlung in im UV-, sichtbaren oder IR-Teil des elektromagnetischen Spektrums liegende Photonen umfaßt, welches zur Umwandlung von γ-Strahlung in durch das Verstärkerteil verstärkbare Strahlung verwendet wird.

4. Verfahren zum Ermitteln von β-Strahlung, bei dem in einem Sensorteil, welches in einem optischen Lichtwellenleiter (1, 2, 2a, 2b, 20) angeordnet ist, β-Strahlung in im UV-, sichtbaren oder IR-Teil des elektromagnetischen Spektrums liegende Photonen umgewandelt und in einem optisch gepumpten (3, 24, 25) Verstärkerteil, welches ebenfalls in dem optischen Lichtwellenleiter (1, 2, 2a, 2b, 20) angeordnet ist, das vom Sensorteil umgewandelte Licht aufgenommen und verstärkend weitergeleitet wird.

5. Verfahren nach Anspruch 4, ***dadurch gekennzeichnet, daß*** das Verstärkerteil durch gepulstes Licht optisch gepumpt wird.

6. Verfahren nach Anspruch 4 oder 5, ***dadurch gekennzeichnet, daß*** der Lichtwellenleiter (1, 2) zumindest teilweise von einem Fluid, welches β-Strahler enthält bzw. enthalten kann, umspült wird.

7. Vorrichtung zum Ermitteln von β-Strahlung mit mindestens einem Erfassungselement, das ein Sensorteil und ein optisches Verstärkerteil aufweist, das vom Sensorteil gewandeltes Licht aufnimmt, zur weiteren Verarbeitung weiterleitet und dabei verstärkt und der wenigstens einen optischen Lichtwellenleiter (1, 2, 2a, 2b, 20) aufweist, dessen Material zur Lichtverstärkung zumindest teilweise optisch gepumpt (3, 24, 25) ist, ***dadurch gekennzeichnet, daß*** der optische Lichtwellenleiter (1, 2, 2a, 2b, 20) ein Sensorteil zur Umwandlung von β-Strahlung in im UV-, sichtbaren oder IR-Teil des elektromagnetischen Spektrums liegende Photonen umfaßt, welches zur Umwandlung von β-Strahlung in durch das Verstärkerteil verstärkbare Strahlung verwendet wird.

8. Vorrichtung nach Anspruch 7, ***dadurch gekennzeichnet, daß*** der Lichtwellenleiter (1, 2) einen Behälter (30) mit einem Einlaß (31) und einem Auslaß (32) für ein Fluid (33), welches den Lichtwellenleiter (1, 2) umspült und β-Strahler (35) enthält bzw. enthalten kann, durchsetzt.

## Claims

1. A method for detecting γ-rays whereby in a sensor section, which is placed in an optical light wave conductor (1, 2, 2a, 2b, 20), γ-rays are converted into photons lying in the UV, visible or IR part of the electro-magnetic spectrum, and the light converted in the sensor section is received in an optically pumped amplifier section (3, 24, 25), which is also placed in the optical light wave conductor (1, 2, 2a, 2b, 20), and transmitted further in amplified form.

2. The method in accordance with claim 1, **characterised in that** the amplifier section is optically pumped by pulsed light.

3. A device for detecting γ-rays with at least one detecting element having a sensor section and an optical amplifier section, said amplifier receiving the light converted by the sensor section, transmitting it for further processing while simultaneously amplifying it, and said amplifier having at least one optical light wave conductor (1, 2, 2a, 2b, 20) whose material for light amplification is at least in part optically pumped (3, 24, 25), **characterised in that** the optical light wave conductor (1, 2, 2a, 2b, 20) comprises a sensor section for the conversion of γ-rays into photons lying in the UV, visible or IR part of the electro-magnetic spectrum, said sensor section being used for the conversion of γ-rays into radiation capable of being amplified by the amplifier section.

4. A method for detecting β-rays whereby in a sensor section, which is placed in an optical light wave conductor (1, 2, 2a, 2b, 20), β-rays are converted into photons lying in the UV, visible or IR part of the electro-magnetic spectrum, and the light converted in the sensor section is received in an optically pumped amplifier section (3, 24, 25), which is also placed in the optical light wave conductor (1, 2, 2a, 2b, 20), and transmitted further in amplified form.

5. The method in accordance with claim 4, **characterised in that** the amplifier section is optically pumped by pulsed light.

6. The method in accordance with claim 4 or 5,
**characterised in that** the light wave conductor (1, 2) is at least in part surrounded by a fluid which contains or can contain β-ray emitters.

7. A device for detecting β-rays with at least one detecting element having a sensor section and an optical amplifier section, said amplifier receiving the light converted by the sensor section, transmitting it for further processing while simultaneously amplifying it, and said amplifier having at least one optical light wave conductor (1, 2, 2a, 2b, 20) whose material for light amplification is at least in part optically pumped (3, 24, 25), **characterised in that** the optical light wave conductor (1, 2, 2a, 2b, 20) comprises a sensor section for the conversion of β-rays into photons lying in the UV, visible or IR part of the electro-magnetic spectrum, said sensor section being used for the conversion of γ-rays into radiation capable of being amplified by the amplifier section.

8. The device in accordance with claim 7, **characterised in that** the light wave conductor (1, 2) penetrates a vessel (30) with an inlet (31) and an outlet (32) for a fluid (33) which surrounds the light wave conductor (1, 2) and contains or can contain β-ray emitters (35).

## Revendications

1. Procédé de détection de rayons γ, les rayons γ étant convertis en photons ultraviolets, visibles ou infrarouges du spectre électromagnétique dans un capteur disposé dans une fibre optique (1, 2, 2a, 2b, 20) et la lumière convertie par le capteur étant reçue dans un amplificateur pompé optiquement (3, 24, 25) et également disposé dans la fibre optique (1, 2, 2a, 2b, 20) avant d'être transmise, amplifiée.

2. Procédé selon la revendication 1, ***caractérisé en ce que*** l'amplificateur est optiquement pompé par lumière pulsée.

3. Dispositif de détection de rayons γ avec au moins un élément de saisie comportant un capteur et un amplificateur optique qui reçoit la lumière convertie par le capteur, l'achemine, en l'amplifiant, vers un traitement ultérieur et qui est pourvu d'au moins une fibre optique (1, 2, 2a, 2b, 20) dont le matériau a été, du moins en partie, pompé optiquement (3, 24, 25) en vue d'amplifier la lumière, ***caractérisé en ce que*** la fibre optique (1, 2, 2a, 2b, 20) comprend un capteur pour convertir les rayons γ en photons ultraviolets, visibles ou infrarouges du spectre électromagnétique, ledit capteur étant utilisé pour convertir des rayons γ en rayons destinés à être amplifiés par l'amplificateur.

4. Procédé de détection de rayons β, les rayons β étant convertis en photons ultraviolets, visibles ou infrarouges du spectre électromagnétique dans un capteur disposé dans une fibre optique (1, 2, 2a, 2b, 20) et la lumière convertie par le capteur étant reçue dans un amplificateur pompé optiquement (3, 24, 25) et également disposé dans la fibre optique (1, 2, 2a, 2b, 20) avant d'être transmise, amplifiée.

5. Procédé selon la revendication 4, ***caractérisé en ce que*** l'amplificateur est optiquement pompé par lumière pulsée.

6. Procédé selon la revendication 4 ou 5, ***caractérisé en ce que*** la fibre optique (1, 2) baigne, du moins en partie, dans un fluide contenant ou pouvant contenir des émetteurs β.

7. Dispositif de détection de rayons β avec au moins un élément de saisie comportant un capteur et un amplificateur optique qui reçoit la lumière convertie par le capteur, l'achemine, en l'amplifiant, vers un traitement ultérieur, et qui est pourvu d'au moins une fibre optique (1, 2, 2a, 2b, 20) dont le matériau a été, du moins en partie, pompé optiquement (3, 24, 25) en vue d'amplifier la lumière, ***caractérisé en ce que*** la fibre optique (1, 2, 2a, 2b, 20) comprend un capteur pour convertir les rayons γ en photons ultraviolets, visibles ou infrarouges du spectre électromagnétique, ledit capteur étant utilisé pour convertir des rayons β en rayons destinés à être amplifiés par l'amplificateur.

8. Dispositif selon la revendication 7, ***caractérisé en ce que*** la fibre optique (1, 2) pénètre un récipient (30) avec une entrée (31) et une sortie (32) pour un fluide (33) qui contient ou peut contenir des émetteurs β (35) et dans lequel la fibre optique (1, 2) baigne.
